# EUROPEAN PATENT APPLICATION

(11) **EP 4 087 127 A1**
(43) Date of publication of application: **09.11.2022**
(21) Application number: 20908749.3
(22) Date of filing: 06.05.2020
(51) Int. Cl.: H03H 9/02

(54) **SEMICONDUCTOR STRUCTURE HAVING STACKING UNIT AND MANUFACTURING METHOD THEREFORE, AND ELECTRONIC DEVICE**

(30) Priority: 31.12.2019 CN 201911424781
(71) Applicant: Rofs Microsystem (Tianjin) Co., Ltd, Tianjin 300462 (CN)
(72) Inventor: WEN, Pan, Tianjin 300462 (CN); PANG, Wei, Tianjin 300072 (CN); ZHANG, Lanyue, Tianjin 300462 (CN); ZHANG, Wei, Tianjin 300462 (CN); YANG, Qingrui, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/088728
(87) International publication number: WO 2021/135018

(57) **Abstract**

The present disclosure relates to a semiconductor structure having a stacking unit, including: a protective layer; and multiple units sequentially stacked on the lower surface of the protective layer in the thickness direction of the protective layer, each unit including a substrate. At least one middle unit is located between the protective layer and the lowermost one of the multiple units. The upper surface of the substrate of the middle unit is provided with multiple bonding structures. Each bonding structure includes a barrier layer and an upper metal bonding layer in order from bottom to top. The material of the barrier layer is different from the material of the substrate where said barrier layer is disposed and the material of the upper metal bonding layer. The middle unit is provided with multiple middle substrate conductive through holes passing through the substrate thereof, the middle substrate conductive through holes pass upward through the barrier layer of the corresponding bonding structure to be electrically connected to the upper metal bonding layer, and the lower ends of the middle substrate conductive through holes are electrically connected to the corresponding unit below the middle unit. The present disclosure also relates to a manufacturing method for the semiconductor structure having a stacking unit, and an electronic device having the structure.

## Description

### TECHNICAL FIELD

Embodiments of the present disclosure relates to the field of semiconductors, and in particular, to a semiconductor structure and a manufacturing method thereof, and an electronic apparatus having the semiconductor structure.

### BACKGROUND

With rapid development of the wireless communication technologies and increasingly extensive application of the miniaturized portable terminal apparatus, a demand for high-performance and small-size RF front-end modules and devices is increasing. In recent years, based on, for example, a Film Bulk Acoustic Resonator (FBAR), filters, diplexers and other filter devices have become more and more popular in the market. This is because on the one hand, they have excellent electrical properties such as low insertion loss, steep transition characteristics, high selectivity, high power capacity, strong electrostatic discharge (ESD) resistance, and on the other hand, they are small in volume and easy to be integrated.

However, it is required to further reduce a dimension of a filter device.

### SUMMARY

In order to alleviate or solve at least one aspect of above problems in the prior art, the present disclosure is provided.

According to an aspect of embodiments of the present disclosure, there is provided a semiconductor structure with stacked units that includes a protective layer and a plurality of units. The protective layer has an upper surface and a lower surface. The plurality of units are sequentially stacked on the lower surface of the protective layer along a thickness direction of the protective layer, and each of the plurality of units includes a substrate. A first accommodating space is provided between the protective layer and a substrate of a topmost unit of the plurality of units, and a second accommodating space is provided between substrates of two adjacent stacked upper and lower units of the plurality of units. A substrate of at least one of the plurality of units is provided with a chip that is located in a corresponding one of the first accommodating space and the second accommodating space. The plurality of units includes at least one intermediate unit, the at least one intermediate unit is located between the protective layer and a lowermost unit of the plurality of units. The at least one intermediate unit is provided with a plurality of bonding structures on an upper surface thereof, each of the plurality of bonding structures includes a barrier layer and an upper metal bonding layer arranged sequentially from bottom to top, and the barrier layer is made of a material that is different from a material of the substrate where the barrier layer is located and is different from a material of the upper metal bonding layer. The at least one intermediate unit includes a plurality of intermediate substrate conductive through holes passing through the substrate thereof. Each of the plurality of intermediate substrate conductive through holes passes through a barrier layer of one bonding structure of the plurality of bonding structures upwardly to be electrically connected to an upper metal bonding layer of the one bonding structure. The intermediate substrate conductive through hole has a lower end electrically connected to one corresponding unit of the plurality of units located below the at least one intermediate unit.

An embodiment of the present disclosure further relates to a method of manufacturing a semiconductor structure with stacked units. The method includes: providing a protective layer having an upper surface and a lower surface; providing a plurality of units, each of the plurality of units including a substrate, the plurality of units including at least one intermediate unit located between the protective layer and a lowermost unit of the plurality of units; and sequentially stacking the plurality of units on the lower surface of the protective layer in a thickness direction of the protective layer, a first accommodating space being provided between the protective layer and a substrate of a topmost unit of the plurality of units, a second accommodating space being provided between substrates of two adjacent stacked upper and lower units of the plurality of units, and a substrate of at least one of the plurality of unit being provided with a chip that is located in a corresponding one of the first accommodating space and the second accommodating space. The providing the at least one intermediate unit includes: providing a plurality of bonding structures on an upper surface of a substrate of the at least one intermediate unit, each of the plurality of bonding structures including a barrier layer and an upper metal bonding layer arranged sequentially from bottom to top, and the barrier layer being made of a material that is different from a material of the substrate where the barrier layer is located and is different from a material of the upper metal bonding layer; providing a plurality of protrusion structures on a lower surface of the substrate of the at least one intermediate unit, each of the plurality of protrusion structures being formed by thinning the substrate of the at least one intermediate unit, and each of the plurality of protrusion structures corresponding to one bonding structure of the plurality of bonding structures and align with the one bonding structure in a thickness direction of the substrate of the at least one intermediate unit; performing, by a first etching process, a first etching step on the lower surface of the substrate of the at least one intermediate unit to form intermediate substrate through holes, each of the intermediate substrate through holes passing through one of the plurality of protrusion structures and the substrate of the at least one intermediate unit and terminating at a barrier layer of the one bonding structure; performing, by a different etching process, a second etching step on the lower surface of the substrate of the at least one intermediate unit, in such a manner that the intermediate substrate through hole further extends through the barrier layer and terminates at the upper metal bonding layer; and filling the intermediate substrate through holes with a conductive metal to form intermediate substrate conductive through holes.

The method further includes filling the intermediate substrate through holes with a conductive metal to form an intermediate substrate conductive through hole.

An embodiment of the present disclosure further relates to an electronic apparatus having the semiconductor structure as described above.

### BRIEF DESCRIPTION OF DRAWINGS

The following description and drawings can facilitate to understand these and other features and advantages in various embodiments disclosed in the present disclosure. The same reference signs in the drawings always indicate the same components.
FIGS. 1A to 1D are schematic sectional views illustrating a semiconductor structure in a known stacked design, in which a sidewall of a protective through hole cannot be completely filled by a photoresist when a protrusion structure on a back surface of the substrate is further processed based on an existing hole, and the figures show partially enlarged views of the photoresist entering into the through hole and etching of a hole edge due to lack of photoresist protection.
FIGS. 2A to 2B are schematic diagrams showing that a hole depth is not easy to be controlled when an alignment structure on the back surface of the substrate is processed and then a through hole structure is processed.
FIG. 3 is a schematic sectional view of an acoustic wave duplexer according to an exemplary embodiment of the present disclosure.
FIG. 3A is a partially enlarged schematic diagram of a ring portion in FIG. 3.
FIG. 4A is a schematic sectional view showing a manufacturing process of the acoustic wave duplexer in FIG. 3, showing a state in which no through hole has been etched on a substrate and only one device unit is stacked under a protective layer.
FIG. 4B is a schematic sectional view showing a manufacturing process of the acoustic wave duplexer in FIG. 3, showing a state in which a through hole has been etched in the substrate of the one device unit.
FIGS. 5A to 5D are schematic diagrams illustratively showing a manufacturing process of forming the through hole in FIG. 3.
FIG. 6 is a schematic sectional view of an acoustic wave duplexer according to another exemplary embodiment of the present disclosure, in which a conductive through hole is integral with and electrically connected to a lowermost device unit, and extends downwards from an upper surface of a protective layer.
FIG. 6A is a schematic enlarged diagram of a ring portion in FIG. 6.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

An existing semiconductor wafer-level package is obtained by direct alignment bonding of a capping layer (protective layer) and a wafer. Athrough hole is formed in the capping layer, and the bonded capping layer is ground and thinned to expose the through hole. After that, a conductive metal is filled in the through hole to be electrically connected to a conductive pad in the substrate, thereby achieving external electrical connection of a device on the substrate.

The bonding operations require etching a through hole structure on both the capping layer and a stacked substrate, and thus electrical connection between wafers and the outside can be achieved by forming the through hole on a back surface of the substrate of the bonded device.

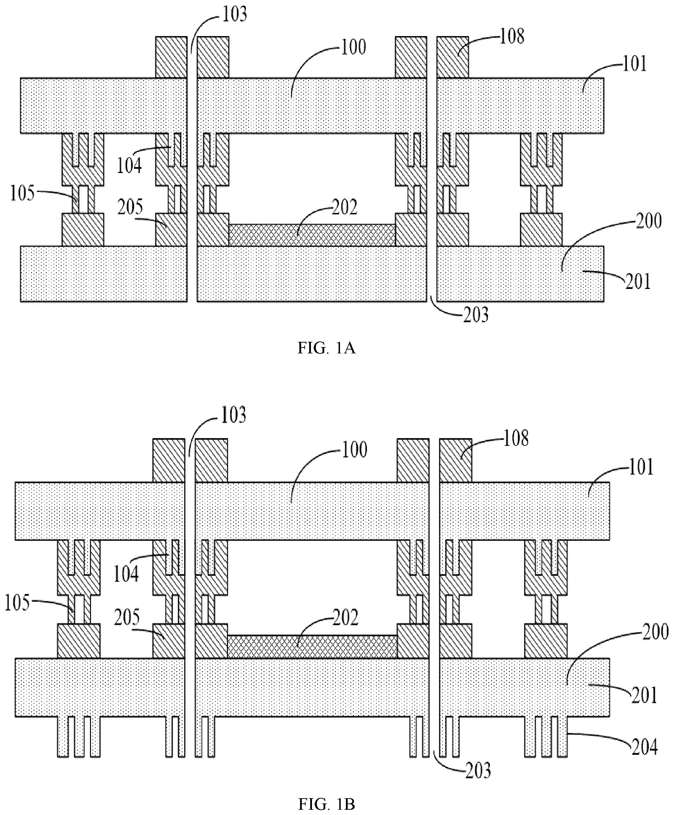

The multi-layer bonding structure is required for the intermediate substrate to have a through hole to electrically connect components of each layer to the outside. In general, the bonded intermediate substrate is grinded to expose the through hole on a side of the intermediate substrate, as shown in FIG. 1A. However, a protrusion structure, for example 204 in FIG. 1B, needs to be formed on a back surface of a bonded substrate 201 for alignment. The bonded substrate with the through hole is grinded to expose the through hole on the back surface of the substrate. It may be more difficult to prepare the protrusion structure 204 after the through hole is formed. Since the protrusion structure is arranged around the through hole, a photoresist is ideally used to completely cover the through hole during the etching of the protrusion structure. In this way, the inside of the through hole is protected from being etched to damage a profile of a side wall thereof, otherwise which easily lead to breaking when the conductive metal is filled in the through hole to result in poor electrical contact, increased loss, or even more seriously failure to realize electric conduction and thus have a low product yield.

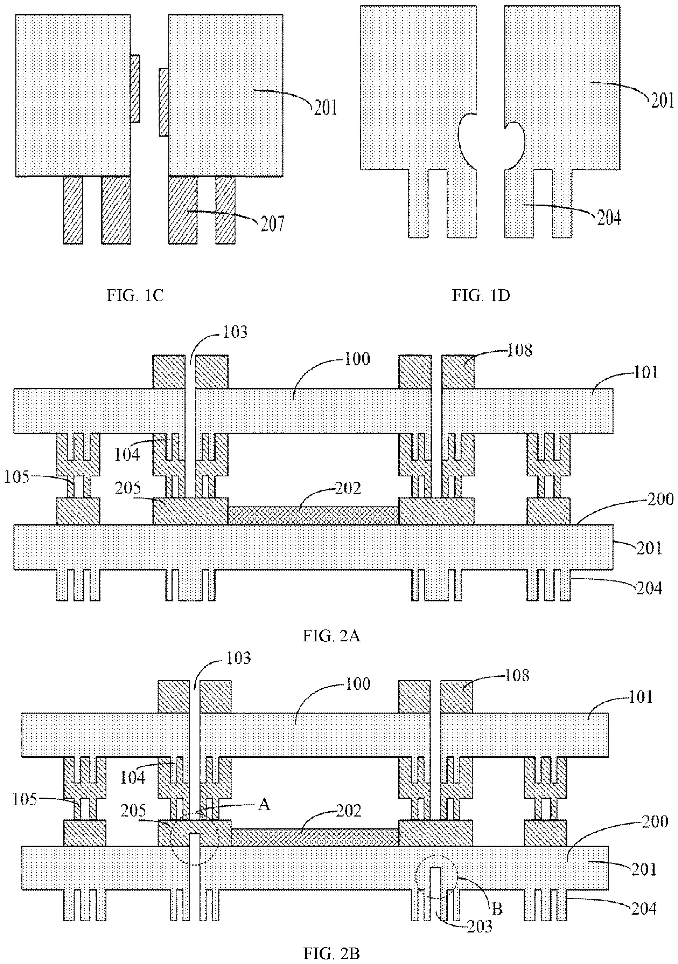

However, the through hole has a large aspect ratio. Accordingly, after the photoresist is spin-coated and then baked, air in the through hole is heated and expanded to cause the photoresist on a surface of the through hole to collapse and partially adhere to an inner wall of the through hole, as shown in the enlarged view of FIG. 1C. That is, the photoresist 207 enters the through hole and cannot completely cover the sidewall of the through hole. Therefore, in a further etching process, areas that are not covered by the photoresist are etched, resulting in an abnormal profile of the through hole, as shown in FIG. 1D.

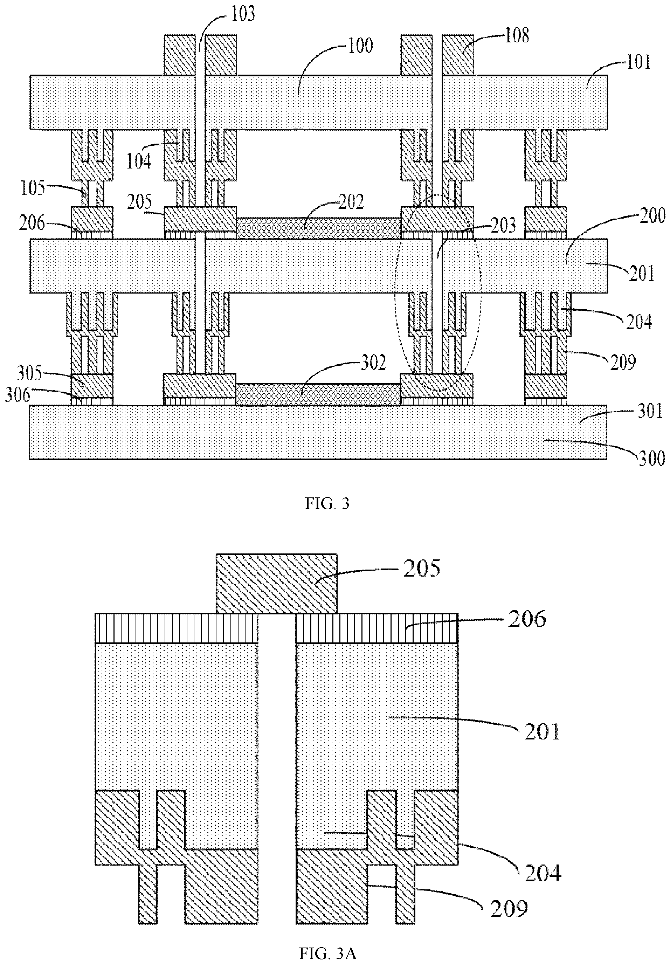

In the present disclosure, a method of manufacturing the through hole on a back surface is further provided on a basis of providing the technical solution of stacked arrangement. Based on an existing structure, the existing semiconductor wafer-level package is formed by directly aligning and bonding a capping layer (the protective layer) and a wafer, and there is no hole structure etched on the intermediate substrate. Therefore, a protrusion structure 204 is etched on a back surface of the intermediate substrate, as shown in FIG. 2A, and then through holes are etched at a center of the structure 204. At this time, an etching gas has little selectivity to a silicon substrate 201 and a metal layer 205 such that depths of the holes cannot be controlled. Further, depths of the holes in different areas of the whole substrate are different form each other due to inconsistent etching, as shown in FIG. 2B. Therefore, in order to solve this problem in the present disclosure, an etching barrier layer with a predetermined thickness is provided between the metal layer 205 and the substrate 201 in advance, as shown as a layer 206 in FIG. 3. Accordingly, the barrier layer is not etched when the through holes on the substrate are being etched, and the metal layer is not etched when the etching gas is replaced to further etch the barrier layer. This method can not only avoid abnormality of photoresist collapsing in FIG. 1, but also avoid the problem of uncontrollable hole depth in FIG. 2. A through hole structure for good electrical connection can be formed during the preparation of a target protrusion structure, to perform multiple bonding for the substrate. Accordingly, a semiconductor structure with a stacked arrangement is further provided in the present disclosure.

In the disclosure, the semiconductor structure is illustrated by taking an acoustic wave filter as an example. The acoustic wave filter can be electrically connected in a vertical direction in a multi-substrate manner, which can reduce an area of a device, such as a filter, a duplexer, and a quadplexer, by more than 30%. A resonator of the filter will not be limited by processes on the same substrate, thus improving insertion loss performance of the filter.

In an embodiment of the present disclosure, a plurality of resonators of a filter is placed on two or more substrates, and the filter is formed by connecting the plurality of resonators by means of electrical through-hole leads and metal bonding. In an embodiment of the present disclosure, a plurality of filters is placed on two or more substrates, and the plurality of filters is combined into a multiplex filter or other device by electrical through-hole leads and metal bonding.

In an embodiment of the present disclosure, electrical input and output are provided on an upper surface of a protective layer 101 (described later), which is a topmost layer of the semiconductor structure. A lower surface of the corresponding semiconductor structure does not need to be provided with through holes functioning as electrical leads. For example, in FIG. 3, a substrate 300 located at a lower side of the semiconductor structure is not provided with conductive through holes, but the conductive through holes and conductive pads 108 are provided on the upper surface of the protective layer 101.

Metals that are bonded to each other between adjacent substrates have two functions, one is to ensure electrical connection and the other is to ensure sealing property. A metal bonding structure configured to perform electrical connection is merely shown in this figure of the present disclosure.

In an embodiment of the present disclosure, the protective layer 101 is used as a topmost substrate of the semiconductor structure. For example, as shown in the figure, in the semiconductor structure, upward surfaces of the substrates each are an upper surface, and downward surfaces of the substrate each are a lower surface.

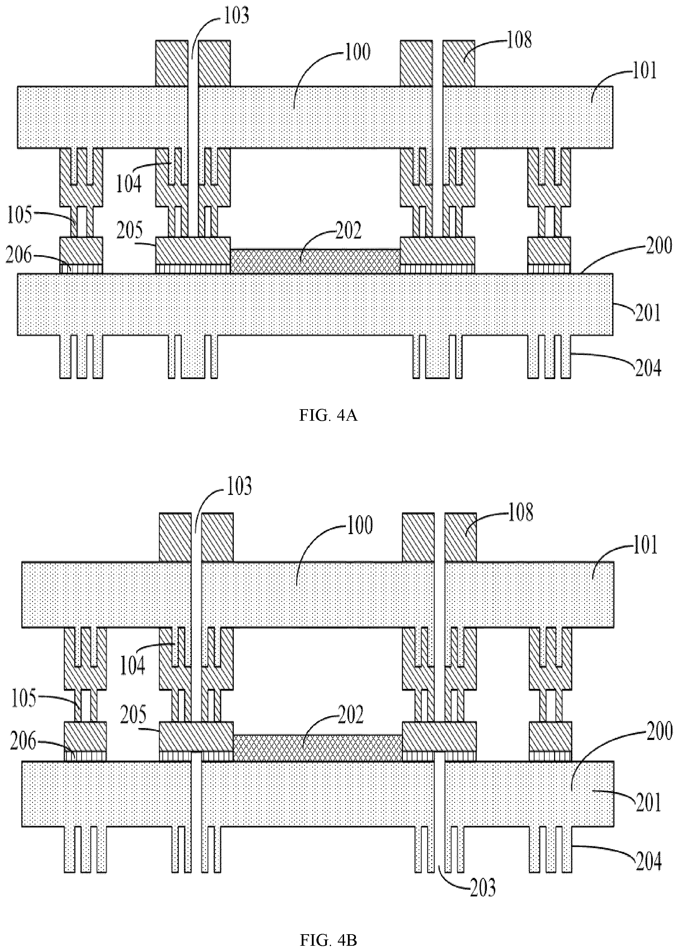

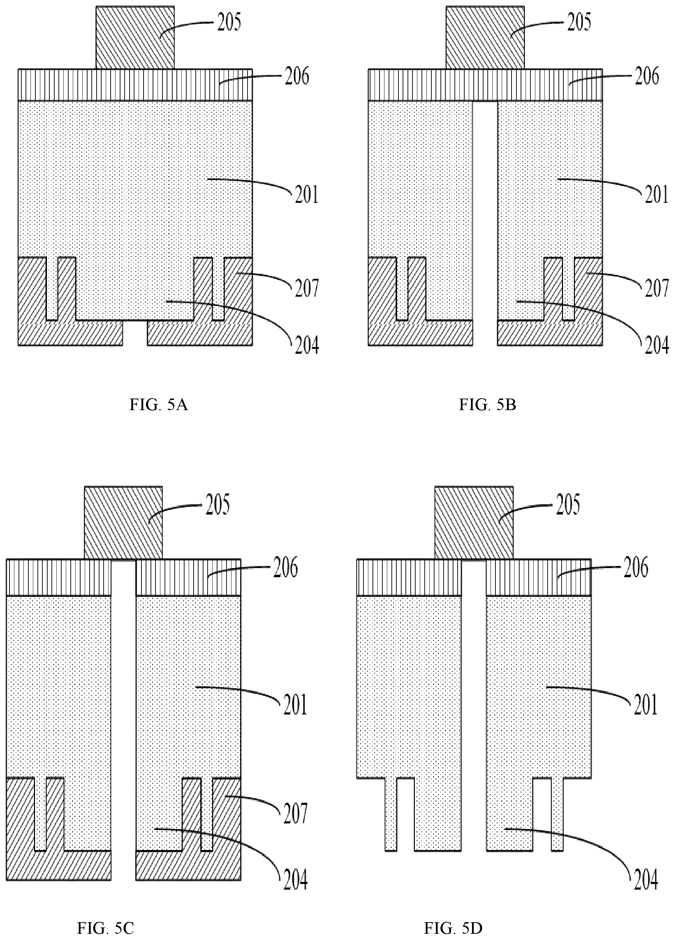

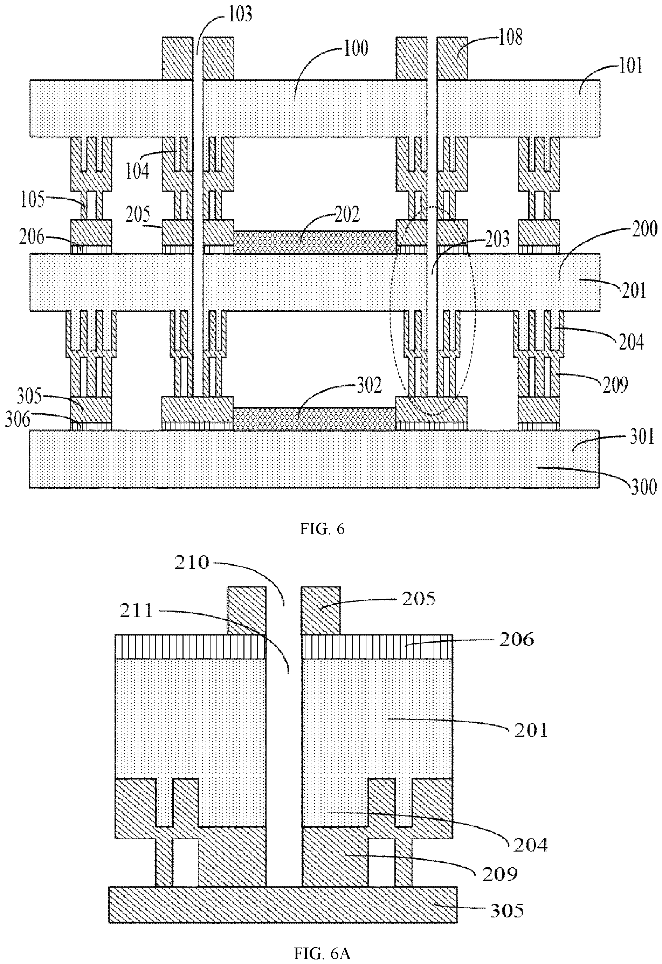

FIG. 3 is a schematic sectional view of an acoustic wave duplexer according to an exemplary embodiment of the present disclosure. FIG. 3A is a partially enlarged schematic diagram of a ring portion in FIG. 3. FIG. 4A is a schematic sectional view showing a manufacturing process of the acoustic wave duplexer in FIG. 3, showing a state in which no through hole has been etched on a substrate and only one device unit is stacked under a protective layer. FIG. 4B is a schematic sectional view showing a manufacturing process of the acoustic wave duplexer in FIG. 3, showing a state in which a through hole has been etched in the substrate of the one device unit. FIGS. 5A to 5D are schematic diagrams illustratively showing a manufacturing process of forming the through hole in FIG. 3. FIG. 6 is a schematic sectional view of an acoustic wave duplexer according to another exemplary embodiment of the present disclosure, in which a conductive through hole is integral with and electrically connected to a lowermost device unit, and extends downwards from an upper surface of a protective layer. FIG. 6A is a schematic enlarged diagram of a ring portion in FIG. 6. In the above drawings, components indicated by reference numerals are described as follows.

100: Protective layer or capping layer, on which a pad is provided.

101: Substrate, which constitutes the protective layer and may be made of a material such as monocrystalline silicon, gallium arsenide, sapphire, and quartz.

103: Protective layer through holes or protective layer conductive through holes. In the present disclosure, the conductive through holes are formed by providing a conductive metal in the through holes, and the conductive metal may be made of a material such as molybdenum, ruthenium, gold, aluminum, magnesium, tungsten, copper, titanium, iridium, osmium, chromium, or composites or alloys thereof.

104: Conductive protrusions, which are provided on a lower surface of the substrate 101 and bonded to the bonding metal layer below the substrate.

105: Bonding enhancement structure, which is provided on the metal bonding layer of the protrusion structure and may be a convex-concave structure.

201: First substrate, which may be made of a material such as monocrystalline silicon, gallium arsenide, sapphire, and quartz.

301: Second substrate, which may be made of a material such as monocrystalline silicon, gallium arsenide, sapphire, and quartz.

200: First device unit, which, for example, is a single acoustic wave resonator or an electrical connection structure of a plurality of acoustic wave resonators disposed on an upper surface of the first substrate.

202: First device or device functional region, which is provided on the first substrate and is for example an acoustic wave resonator. The first device or device functional region includes, but is not limited to, an acoustic mirror, which may be a cavity, or may employ a Bragg reflection layer or other equivalent forms; a top electrode (an electrode pin) that may be made of a material such as molybdenum, ruthenium, gold, aluminum, magnesium, tungsten, copper, titanium, iridium, osmium, chromium, or composites or alloys thereof; a piezoelectric film layer, which may be made of a material such as aluminum nitride, zinc oxide, and PZT, and contains the above materials doped with a certain atomic ratio of rare earth element; and a top electrode (an electrode pin), which may be made of a material such as molybdenum, ruthenium, gold, aluminum, magnesium, tungsten, copper, titanium, iridium, osmium, chromium, or composites or alloys thereof.

203: Substrate through holes or substrate conductive through holes.

204: Protrusion structure, which is provided on a lower surface of the first substrate.

205: Bonding metal layer, which may be made of a material of molybdenum, ruthenium, gold, aluminum, magnesium, tungsten, copper, titanium, iridium, osmium, chromium, or composites or alloys thereof.

206: Barrier layer, which may be made of a material such as aluminum nitride, silicon nitride, silicon oxide, or silicon dioxide.

207: Photoresist.

209: Bonding metal layer covering the protrusion structure. The bonding metal layer may be made of a material such as molybdenum, ruthenium, gold, aluminum, magnesium, tungsten, copper, titanium, iridium, osmium, chromium, or composites or alloys thereof.

210: Bonding layer through holes.

300: Second device unit, which, for example, is a single acoustic wave resonator or an electrical connection structure of a plurality of acoustic wave resonators provided on an upper surface of the second substrate.

302: Second device or device functional region, which is provided on the second substrate and is for example an acoustic wave resonator. The second device or device functional region includes, but is not limited to, an acoustic mirror, which may be a cavity, or may employ a Bragg reflection layer or other equivalent forms; a bottom electrode (an electrode pin) which may be made of a material such as molybdenum, ruthenium, gold, aluminum, magnesium, tungsten, copper, titanium, iridium, osmium, chromium, or composites or alloys thereof; a piezoelectric film layer, which may be made of a material such as aluminum nitride, zinc oxide, and PZT, and contains the above materials doped with a certain atomic ratio of rare earth element; and a top electrode (an electrode pin), which may be made of a material such as molybdenum, ruthenium, gold, aluminum, magnesium, tungsten, copper, titanium, iridium, osmium, chromium, or composites or alloys thereof.

305: Bonding metal layer, which may be made of a material such as molybdenum, ruthenium, gold, aluminum, magnesium, tungsten, copper, titanium, iridium, osmium, chromium, or composites or alloys thereof.

306: Device dielectric support layer, which may be made of a material such as aluminum nitride, silicon nitride, silicon oxide, or silicon dioxide.

In an embodiment of the present disclosure, the lower surface and upper surface of the substrate are an upper side face and a lower side face of the substrate in a thickness direction of the substrate, respectively. The single acoustic wave resonator or the electrical connection structure of the plurality of acoustic wave resonators is located on the upper surface of the substrate.

In the embodiments of FIGS. 3 to 6A of the present disclosure, through holes are not provided on the substrate until the protrusion structure is formed.

In FIG. 3, the protective layer through holes 103 pass through the protective layer 101 to be electrically connected to the device on the first substrate 201, and the conductive through holes 203 pass through the first substrate to be electrically connected to the bonding structure on the second substrate 301. As shown in FIG. 6, each of the through holes 103 directly communicates with a corresponding one of the through holes 203 through a corresponding one of the bonding metal through holes 210.

As shown in FIGS. 3 and 6, a protective layer bonding structure (i.e., the conductive protrusions 104) is provided on the lower surface of the protective layer 101 and arranged below the protective layer through holes 103. A bonding structure is provided on the upper surface of the first substrate 201, and includes the bonding metal layer 205. The metal bonding layer 305 is provided on the upper surface of the second substrate 301. When the protective layer 101, the first substrate 201 and the second substrate 301 are stacked, the respective bonding structures are bonded to each other.

As shown in FIGS. 3 and 6, the conductive through hole 103 passes through the corresponding bonding structure until it is electrically connected to one of the bonding structures on the corresponding substrate, which is a substrate where a unit to be electrically connected with the conductive through hole is located. In other words, as can be understood by those skilled in the art, the bonding of adjacent layers (including the bonding between the protective layer and a unit layer and the bonding between unit layers) is achieved through a bonding structure between the adjacent layers. In addition, the connecting through holes provided between the adjacent layers may be formed by a bonding structure.

As shown in FIG. 1, an upper end of each of the conductive through holes is opened or located on an upper surface of the protective layer 101. As shown in FIGS. 3 and 6, a conductive pad 108 is electrically connected with the upper end of the conductive through hole on the upper surface of the protective layer 101.

In addition, as shown in FIGS. 3 to 6A, an intermediate device unit 200 is located between the protective layer or protective layer substrate 101 and the second substrate 301. The intermediate device unit 200 includes the first substrate 201, of which the upper surface is provided with a plurality of bonding structures. Each of the bonding structures includes the barrier layer 206 and the first metal bonding layer 205 that are arranged sequentially from bottom to top, and the barrier layer is made of a material that is different from a material of the first substrate 201 and different from a material of the metal bonding layer 205. The first device unit 200 has a plurality of the intermediate substrate conductive through holes 203 passing through the first substrate 201. Each of the intermediate substrate conductive through holes 203 passes upwardly through the barrier layer 206 of a corresponding one of the bonding structure to be electrically connected to the metal bonding layer 205. An lower end of the intermediate substrate conductive through hole 203 is electrically connected to the second device unit arranged below the first device unit.

In FIGS. 3 to 6A, in a further embodiment, the protective layer 101 and other device units form respective layers, and two adjacent ones of the layers are stacked in such a manner that the metal bonding layers facing each other are bonded to each other. The substrate conductive through hole 203 connects the metal bonding layers 205 and 305 on upper and lower sides of the first substrate 201.

As shown in FIGS. 3 to 6A, a lower surface of a substrate of each intermediate unit is provided with a plurality of protrusion structures 204 integrally formed with the substrate and a metal bonding layer 209 covering the plurality of protrusion structures 204. Each of the plurality of protrusion structures 204 corresponds to one of the bonding structures, and aligns with the corresponding boding structure in a thickness direction of the first substrate of the first device unit 200. As shown in FIG. 3, the substrate conductive through hole 203 passes through the corresponding protrusion structure 204 downwardly to be electrically connected to the metal bonding layer 209 covering the protrusion structure 204.

In a further embodiment, the substrate conductive through hole 203 further passes through the metal bonding layer 209 covering the protrusion structure 204 to reach the bonding metal layer 305 on the second device unit 300.

A connection relationship between the conductive through holes of the substrates, the protective layer and respective device layers are described as follows.

The substrate conductive through hole 203 extends upwardly through the metal bonding layer 205 to be coaxial and electrically communicated with a corresponding one of the conductive through holes 103 provided in the protective layer 101, thereby forming an integrated conductive through hole structure.

In an embodiment, the substrate conductive through hole 203 extends upwardly through the metal bonding layer 205 to be coaxial and electrically communicated with a corresponding one of the conductive through holes provided in an another intermediate device unit above the first device unit 200 in a case where other device units are further provided between the first device unit and the protective layer, thereby forming the integrated conductive through hole structure.

In an embodiment, the substrate conductive through hole 203 extends downwardly to be coaxial and electrically communicated with a corresponding one of the conductive through holes provided in an another intermediate unit below the first device unit 200 in a case where the other device units are further provided between the first device unit 200 and the second device unit 300, thereby forming the integrated conductive through hole structure.

In an embodiment, the substrate conductive through hole 203 extends downwardly to be coaxial and electrically communicated with a corresponding one of the conductive through holes provided in an another intermediate unit below the intermediate unit in a case the other device units are further provided between the first device unit 200 and the second device unit 300), and extends upwardly to be coaxial and electrically connected with a corresponding one of the conductive through holes provided in the other intermediate device unit (in a case where the other device unit is further provided between the first device unit and the protective layer) or the protective layer, thereby forming the integrated conductive through hole structure.

As shown in FIG. 3, the upper surface of the protective layer is provided with the conductive pads 108 electrically connected with the conductive through holes.

In an alternative embodiment, a conductive pillar in the integrated conductive through hole structure is an integrally molded conductive pillar. In a further alternative embodiment, a wall thickness of the conductive metal pillar in the through hole is gradually decreased from top to bottom based on a single filling molding. That is, the integrally molded conductive pillar is a conductive pillar of which a wall thickness is gradually decreased from top to bottom.

In an embodiment of the present disclosure, an effective electrical connection (i.e., conductive through holes) is formed in the conductive through hole 103 of the protective layer 101 and the conductive through hole 203 of the second substrate 201 at one time by an electroplating process. This one-time filling of the conductive through hole can effectively solve or alleviate problems of poor bonding effect in a second time and poor sealing performance caused by separate filling of conductive through holes. Meanwhile, it provides good electrical conduction performance and process steps can be reduced. The conductive pad 108 may be formed after the conductive metal is filled in the through hole.

In the present disclosure, the integrally molding of the conductive pillar means that the conductive pillar is integrally molded through one-time filling of conductive materials, rather than that two conductive through holes are filled separately and then bonded to each other to communicate the two conductive through holes with each other. Since the conductive pillar is integrally molded, the conductive pillar in the present disclosure does not have problems that holes, loose connections, contamination defects and the like are easy to be formed at two metal-filling contacts caused by the bonding operation, as described above.

As shown in FIG. 6, the above integrated conductive through hole structure includes an integrated conductive through hole structure that extends downwardly from the conductive through hole 103 of the protective layer to be electrically connected to a lowermost device unit.

Referring to FIGS. 4Aand 4B and FIGS. 5A to 5D, a method of forming an acoustic wave duplexer by a vertical stacking process is described below.

As shown in FIG. 4A, the structure shown in FIG. 4A is formed firstly, in which a lower surface of the second substrate 201 is provided with a protrusion structure 204, but there is not through hole formed in the second substrate. In FIG. 4A, the protective layer 101 has the protective layer through holes 103 passing therethrough and the conductive protrusions 104 for bonding that are provided on a lower surface of the protective layer. The upper surface of the second substrate is provided with a barrier layer 206 and a bonding metal layer 205 arranged on the barrier layer 206.

As shown in FIG. 4B based on FIG. 4A, the through holes 203 have been formed, and pass through the protrusion structure 204, the first substrate 201, and the barrier layer 206 to be electrically connected to the bonding metal layer 205.

FIGS. 5A to 5D are schematic diagrams illustrating a manufacturing process of forming the through holes in FIG. 4B, which will be described in detail below with reference to the drawings.

As shown in FIG. 5A, a photoresist 207 is provided on the protrusion structure shown in FIG. 3, excluding openings that are located at positions corresponding to the through holes 203.

As shown in FIG. 5B based on FIG. 5A, a first etching is performed by an etching process to obtain the through holes 203 in FIG. 5B, and then the photoresist is removed to obtain the structure in FIG. 5B. However, in FIG. 5B, the through holes 203 terminates at the barrier layer 206. As can be understood, an etchant used in the first etching substantially has no effect on the barrier layer 206, but functions to the protrusion structure. For example, when the substrate is made of silicon, SF₆ and C₄F₈ are used as an etching gas and a passivation protective gas, respectively, to etch the through holes 203 in the protrusion structure and the substrate 201.

As shown in FIG. 5C based on FIG. 5B, a second etching is performed by using the photoresist and the etching process to obtain the structure as shown in FIG. 5C, in which the barrier layer 206 is etched so that the through holes 203 pass through the barrier layer 206. As can be understood, the etchant used in the second etching substantially has no effect on the protrusion structure, but functions to the barrier layer. For example, when the substrate is made of silicon and the barrier layer is made of aluminum nitride, CL₂ and BCL₃ are used as an etching gas and a passivation protective gas, respectively, and the bonding metal layer 205 is used as the etching barrier layer to etch through the barrier layer 206.

As shown in FIG. 5D based on the structure of FIG. 5C, the photoresist is removed.

Finally, the through holes (not shown) are filled with a metal, and a bonding metal layer 209 is provided, as shown in FIG. 3A.

Thereafter, the second device unit 300 is connected with and bonded to the structure in FIG. 4B to obtain the structures shown in FIGS. 3 and 3A, for example.

As mentioned above, although the protective layer and two device unit layers are taken as examples in an example of the present disclosure, the disclosure is not limited to this, for example, more stacked device unit layers may be provided. A device unit with a through hole structure on its back, such as the second device unit, can be bonded to a third device unit, and so on, so as to achieve bonding for multiple times to obtain more stacked structures.

In addition, in the embodiment shown in FIG. 3, the through holes 203 of the first substrate does not communicate with the through holes 203 of the protective layer 101, but the present disclosure is not limited to this. FIG. 6 is a schematic sectional view of an acoustic wave duplexer according to another exemplary embodiment of the present disclosure, in which the conductive through holes each are an integrally molded conductive through hole extending downwardly from an upper surface of a protective layer to be electrically connected to a lowermost device unit. In FIG. 6, the bonding metal layer 205 is further provided with the through holes 210 that each are configured to communicate the through hole 103 with the through hole 203. The through hole 210 can be etched by photolithography or a peeling process, and the through hole 210 is slightly larger than the through hole 103, which facilitates for bonding alignment.

In the disclosure, a bonding metal layer can be made on the protrusion structure of the substrate by sputtering, evaporation and other processes, and at this time, the bonding metal layer also has a protrusion structure, which facilitates for bonding.

In the disclosure, after the second device unit 300 is bonded to the first device unit 200 to complete a secondary bonding, the back surface of the protective layer 101 is thinned by grinding to expose the through holes 103. The through holes 103 are filled by electroplating and the conductive pads 108 are formed by sputtering and evaporation, to complete preparation of the whole semiconductor device as shown in FIGS. 3 and 6, for example.

In a traditional method, if one same filter is added, a whole area may be twice as large as an original one. With a vertical stacking method, the power capacity can be increased without increasing the area. Referring to FIGS. 3 and 6, for example, because the conductive pads are shared between the second device unit and the first device unit. Therefore, in a case where two filters are stacked as shown in FIGS. 3 and 6, their area is unchanged, while the power capacity is increased to about 2 times.

Correspondingly, if four identical filters are connected in parallel, since all of the filters share the conductive pad, the area is unchanged while the power capacity is increased to about 4 times. Similarly, if allowed in requirements (limitation on a height of the filter), the power capacity can be continually increased with this method.

In an alternative embodiment, a series resonator can be formed on an intermediate substrate and a parallel resonator is formed on a lower substrate, so thicknesses of respective layers of the series and parallel resonators can be different and optimized separately. Specifically, a thickness of at least one of the top electrode, the piezoelectric layer, the bottom electrode and a passivation layer of the series resonator of a same filter is different from a respective one of thicknesses of the top electrode, the piezoelectric layer, the bottom electrode and the passivation layer of the parallel resonator of the same filter. It should be noted that the "passivation layer" herein does not mean that the resonator must have a passivation layer, but that a thickness of the passivation layer of the series resonator can be different from that of the parallel resonator when the resonator has the passivation layer.

It should be noted that all of series resonators of a filter need to be arranged on a same substrate, and in this way, it can be ensured that electrical impedance between series resonators is as small as possible and deterioration of filter insertion loss can be avoided. Parallel resonators of the filter can be arranged on different substrates.

In view of the above, the present disclosure provides following technical solutions.
1. A semiconductor structure with stacked units includes:
   a protective layer having an upper surface and a lower surface; and
   a plurality of units sequentially stacked on the lower surface of the protective layer along a thickness direction of the protective layer, each of the plurality of units including a substrate, a first accommodating space being provided between the protective layer and a substrate of a topmost unit of the plurality of units, a second accommodating space being provided between substrates of two adjacent stacked upper and lower units of the plurality of units, and a substrate of at least one of the plurality of units being provided with a chip that is located in a corresponding one of the first accommodating space and the second accommodating space,
   wherein the plurality of units includes at least one intermediate unit, the at least one intermediate unit is located between the protective layer and a lowermost unit of the plurality of units, the at least one intermediate unit is provided with a plurality of bonding structures on an upper surface thereof, each of the plurality of bonding structures includes a barrier layer and an upper metal bonding layer arranged sequentially from bottom to top, and the barrier layer is made of a material that is different from a material of the substrate where the barrier layer is located and is different from a material of the upper metal bonding layer; and
   the at least one intermediate unit includes a plurality of intermediate substrate conductive through holes passing through the substrate thereof, each of the plurality of intermediate substrate conductive through holes passes through a barrier layer of one bonding structure of the plurality of bonding structures upwardly to be electrically connected to an upper metal bonding layer of the one bonding structure, and the intermediate substrate conductive through hole has a lower end electrically connected to one corresponding unit of the plurality of units located below the at least one intermediate unit.
2. The semiconductor structure according to 1, wherein
   the protective layer and the plurality of units each form a layer, and two adjacent layers are stacked in such a manner that metal bonding layers of the two adjacent layers facing each other are bonded to each other; and the intermediate substrate conductive through hole is connected to the metal bonding layers located on upper and lower sides of an intermediate substrate of the intermediate unit.
3. The semiconductor structure according to 1 or 2, wherein
   a lower surface of a substrate of each of the at least one intermediate unit is provided with a plurality of protrusion structures integrally formed with the substrate and a lower metal bonding layer covering the protrusion structures, and each of the plurality of protrusion structures corresponds to one bonding structure of the plurality of bonding structures and align with the one bonding structure in a thickness direction of the substrate of the intermediate unit; and the intermediate substrate conductive through hole passes through the protrusion structure downwardly to be electrically connected to the lower metal bonding layer covering the protrusion structure.
4. The semiconductor structure according to 3, wherein
   the intermediate substrate conductive through hole further passes through the lower metal bonding layer covering the protrusion structure.
5. The semiconductor structure according to any one of 1 to 4, wherein
   the intermediate substrate conductive through hole extends upwardly through one of the upper metal bonding layers, in such a manner that the intermediate substrate conductive through hole is coaxial and electrically communicated with a corresponding one of conductive through holes provided in the protective layer to form an integrated conductive through hole structure; or
   the intermediate substrate conductive through hole extends upwardly through one of the upper metal bonding layers, in such a manner that the intermediate substrate conductive through hole is coaxial and electrically communicated with a corresponding one of conductive through holes provided in an another intermediate unit above the intermediate unit to form an integrated conductive through hole structure; or
   the intermediate substrate conductive through hole extends downwardly, in such a manner that the intermediate substrate conductive through hole is coaxial and electrically communicated with a corresponding one of the conductive through holes provided in an another intermediate unit below the intermediate unit to form an integrated conductive through hole structure; or
   the intermediate substrate conductive through hole extends downwardly in such a manner that the intermediate substrate conductive through hole is coaxial and electrically communicated with the corresponding one of the conductive through holes provided in the another intermediate unit below the intermediate unit, and extends upwardly in such a manner that the intermediate substrate conductive through hole is coaxial and electrically communicated with a corresponding one of the conductive through holes provided in an another intermediate unit or the protective layer, thereby forming an integrated conductive through hole structure.
6. The semiconductor structure according to 5, wherein
   the semiconductor structure further includes conductive pads, and the conductive pads are provided on the upper surface of the protective layer and electrically connected to the integrated conductive through hole structure.
7. The semiconductor structure according to 6, wherein
   the integrated conductive through hole structure is provided with conductive pillars, and each of the conductive pillars is an integrally molded conductive pillar.
8. The semiconductor structure according to 7, wherein
   the integrally molded conductive pillar is a conductive pillar that has a wall thickness gradually decreasing from top to bottom.
9. The semiconductor structure according to any one of 5 to 8, wherein
   the integrated conductive through hole structure includes an integrated conductive through hole structure that extends downwardly from the conductive through hole of the protective layer to be electrically connected to the lowermost device unit.
10. The semiconductor structure according to any one of 1 to 9, wherein
   one of the two adjacent stacked upper and lower units is a series resonator unit including a plurality of series resonators, and another one of the two adjacent stacked upper and lower units is a parallel resonator unit including a plurality of parallel resonators.
11. The semiconductor structure according to 10, wherein
   at least one of thicknesses of a piezoelectric layer, a top electrode, a bottom electrode and a passivation layer of the series resonator is different from a corresponding one of thicknesses of a piezoelectric layer, a top electrode, a bottom electrode and a passivation layer of the parallel resonator.
12. The semiconductor structure according to any one of 1 to 9, wherein
   one of the two adjacent stacked upper and lower units is a receiving filter unit, and another one of the two adjacent stacked upper and lower units is a transmitting filter unit.
13. The semiconductor structure according to any one of 1 to 9, wherein
   the semiconductor structure includes at least one filter, each of the at least one filter includes series resonators and parallel resonators, the series resonators of a same filter of the at least one filter are arranged on one substrate of the substrates, and the parallel resonators of the same filter are arranged on another substrate of the substrates that is different from the one substrate; or the semiconductor structure includes at least one filter, each of the at least one filter includes series resonators and parallel resonators, a thickness of at least one of a top electrode, a piezoelectric layer, a bottom electrode and a passivation layer of the series resonator of a same filter is different from a corresponding one of thicknesses of a top electrode, a piezoelectric layer, a bottom electrode and a passivation layer of the parallel resonator of the same filter.
14. The semiconductor structure according to 1, wherein
   the barrier layer is made of at least one of aluminum nitride, silicon nitride, silicon oxide, or silicon dioxide.
15. A method of manufacturing a semiconductor structure with stacked units includes:
   providing a protective layer having an upper surface and a lower surface;
   providing a plurality of units, each of the plurality of units including a substrate, the plurality of units including at least one intermediate unit located between the protective layer and a lowermost unit of the plurality of units; and sequentially stacking the plurality of units on the lower surface of the protective layer in a thickness direction of the protective layer, a first accommodating space being provided between the protective layer and a substrate of a topmost unit of the plurality of units, a second accommodating space being provided between substrates of two adjacent stacked upper and lower units of the plurality of units, and a substrate of at least one of the plurality of unit being provided with a chip that is located in a corresponding one of the first accommodating space and the second accommodating space,
   wherein the providing the at least one intermediate unit includes:
      providing a plurality of bonding structures on an upper surface of a substrate of the at least one intermediate unit, each of the plurality of bonding structures including a barrier layer and an upper metal bonding layer arranged sequentially from bottom to top, and the barrier layer being made of a material that is different from a material of the substrate where the barrier layer is located and is different from a material of the upper metal bonding layer;
      providing a plurality of protrusion structures on a lower surface of the substrate of the at least one intermediate unit, each of the plurality of protrusion structures being formed by thinning the substrate of the at least one intermediate unit, and each of the plurality of protrusion structures corresponding to one bonding structure of the plurality of bonding structures and align with the one bonding structure in a thickness direction of the substrate of the at least one intermediate unit;
      performing, by a first etching process, a first etching step on the lower surface of the substrate of the at least one intermediate unit to form intermediate substrate through holes, each of the intermediate substrate through holes passing through one of the plurality of protrusion structures and the substrate of the at least one intermediate unit and terminating at a barrier layer of the one bonding structure;
      performing, by a different etching process, a second etching step on the lower surface of the substrate of the at least one intermediate unit, in such a manner that the intermediate substrate through hole further extends through the barrier layer and terminates at the upper metal bonding layer; and
      filling the intermediate substrate through holes with a conductive metal to form intermediate substrate conductive through holes.
16. The method according to 15, wherein
   the protective layer and the plurality of unit each form a layer, and two adjacent layers are stacked in a metal bonding mode; the method further includes providing a metal protrusion structure bonding layer on the protrusion structure; and wherein the metal protrusion structure bonding layer is electrically connected to a corresponding one of the intermediate substrate conductive through holes.
17. The method according to 16, wherein
   the upper metal bonding layer arranged on an upper side of the substrate of the intermediate unit has a metal bonding through hole aligning with a corresponding one of the intermediate substrate through holes; and the metal protrusion structure bonding layer arranged on a lower side of the substrate of the intermediate unit has a metal bonding through hole aligning with a corresponding one of the intermediate substrate through holes.
18. The method according to 17, wherein
   the intermediate substrate through hole is a part of an integrated through hole structure extending from the upper surface of the protective layer downwardly through the at least one intermediate unit.
19. The method according to 18, wherein
   the intermediate substrate through hole is a part of an integrated through hole structure that extends from the upper surface of the protective layer downwardly through the at least one intermediate unit to be electrically connected to the lowermost unit.
20. The method according to 18 or 19, wherein
   the filling the intermediate substrate through hole with the conductive metal includes filling the integrated conductive through hole structure with the conductive metal at one time from the upper surface of the protective layer to form an integrated conductive through hole structure.
21. The method according to any one of 15 to 20, wherein
   in the providing the protective layer, the protective layer is provided with protective layer holes partially entering from the lower surface of the protective layer, and the protective layer hole aligns with the intermediate substrate through hole; and
   the method further includes thinning the protective layer from the upper surface of the protective layer to expose the protective layer holes, in such a manner that the protective layer holes each are a protective layer through hole.
22. The method according to 21, wherein
   the method further includes forming conductive pads on the upper surface of the protective layer, and each of the conductive pads is electrically connected to one of the protective layer through holes.
23. An electronic apparatus includes the semiconductor structure according to any one of 1 to 14 or a semiconductor structure manufactured by the method according to any one of 15 to 22.

In the present disclosure, the semiconductor structure may be a filter, a duplexer, a multiplexer, etc. As can be understood, the semiconductor structure can also be other structures based on chips with different unit configurations. In the present disclosure, the chip may include a semiconductor device, such as a microelectromechanical device, an active or passive semiconductor device or the like.

The electronic device herein includes, but is not limited to, an intermediate product such as an RF front end, a filtering and amplifying module; and a terminal product such as a mobile phone, WIFI and a drone.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A semiconductor structure with stacked units, comprising:
a protective layer having an upper surface and a lower surface; and
a plurality of units sequentially stacked on the lower surface of the protective layer along a thickness direction of the protective layer, each of the plurality of units comprising a substrate, a first accommodating space being provided between the protective layer and a substrate of a topmost unit of the plurality of units, a second accommodating space being provided between substrates of two adjacent stacked upper and lower units of the plurality of units, and a substrate of at least one of the plurality of units being provided with a chip that is located in a corresponding one of the first accommodating space and the second accommodating space,
wherein the plurality of units comprises at least one intermediate unit, the at least one intermediate unit is located between the protective layer and a lowermost unit of the plurality of units, the at least one intermediate unit is provided with a plurality of bonding structures on an upper surface thereof, each of the plurality of bonding structures comprises a barrier layer and an upper metal bonding layer arranged sequentially from bottom to top, and the barrier layer is made of a material that is different from a material of the substrate where the barrier layer is located and is different from a material of the upper metal bonding layer; and
where the at least one intermediate unit comprises a plurality of intermediate substrate conductive through holes passing through the substrate thereof, each of the plurality of intermediate substrate conductive through holes passes through a barrier layer of one bonding structure of the plurality of bonding structures upwardly to be electrically connected to an upper metal bonding layer of the one bonding structure, and the intermediate substrate conductive through hole has a lower end electrically connected to one corresponding unit of the plurality of units located below the at least one intermediate unit.

2. The semiconductor structure according to claim 1, wherein the protective layer and the plurality of units each form a layer, and two adjacent layers are stacked in such a manner that metal bonding layers of the two adjacent layers facing each other are bonded to each other; and
the intermediate substrate conductive through hole is connected to the metal bonding layers located on upper and lower sides of an intermediate substrate of the intermediate unit.

3. The semiconductor structure according to claim 1 or 2, wherein a lower surface of a substrate of each of the at least one intermediate unit is provided with a plurality of protrusion structures integrally formed with the substrate and a lower metal bonding layer covering the protrusion structures, and each of the plurality of protrusion structures corresponds to one bonding structure of the plurality of bonding structures and align with the one bonding structure in a thickness direction of the substrate of the intermediate unit; and
the intermediate substrate conductive through hole passes through the protrusion structure downwardly to be electrically connected to the lower metal bonding layer covering the protrusion structure.

4. The semiconductor structure according to claim 3, wherein the intermediate substrate conductive through hole further passes through the lower metal bonding layer covering the protrusion structure.

5. The semiconductor structure according to any one of claims 1 to 4, wherein the intermediate substrate conductive through hole extends upwardly through one of the upper metal bonding layers, in such a manner that the intermediate substrate conductive through hole is coaxial and electrically communicated with a corresponding one of conductive through holes provided in the protective layer to form an integrated conductive through hole structure; or
the intermediate substrate conductive through hole extends upwardly through one of the upper metal bonding layers, in such a manner that the intermediate substrate conductive through hole is coaxial and electrically communicated with a corresponding one of conductive through holes provided in an another intermediate unit above the intermediate unit to form an integrated conductive through hole structure; or
the intermediate substrate conductive through hole extends downwardly, in such a manner that the intermediate substrate conductive through hole is coaxial and electrically communicated with a corresponding one of the conductive through holes provided in an another intermediate unit below the intermediate unit to form an integrated conductive through hole structure; or
the intermediate substrate conductive through hole extends downwardly in such a manner that the intermediate substrate conductive through hole is coaxial and electrically communicated with the corresponding one of the conductive through holes provided in the another intermediate unit below the intermediate unit, and extends upwardly in such a manner that the intermediate substrate conductive through hole is coaxial and electrically communicated with a corresponding one of the conductive through holes provided in an another intermediate unit or the protective layer, thereby forming an integrated conductive through hole structure.

6. The semiconductor structure according to claim 5, further comprising:
conductive pads provided on the upper surface of the protective layer, the conductive pads being electrically connected to the integrated conductive through hole structure.

7. The semiconductor structure according to claim 6, wherein the integrated conductive through hole structure is provided with conductive pillars, and each of the conductive pillars is an integrally molded conductive pillar.

8. The semiconductor structure according to claim 7, wherein the integrally molded conductive pillar is a conductive pillar that has a wall thickness gradually decreasing from top to bottom.

9. The semiconductor structure according to any one of claims 5 to 8, wherein the integrated conductive through hole structure comprises an integrated conductive through hole structure that extends downwardly from the conductive through hole of the protective layer to be electrically connected to the lowermost device unit.

10. The semiconductor structure according to any one of claims 1 to 9, wherein one of the two adjacent stacked upper and lower units is a series resonator unit comprising a plurality of series resonators, and another one of the two adjacent stacked upper and lower units is a parallel resonator unit comprising a plurality of parallel resonators.

11. The semiconductor structure according to claim 10, wherein at least one of thicknesses of a piezoelectric layer, a top electrode, a bottom electrode and a passivation layer of the series resonator is different from a corresponding one of thicknesses of a piezoelectric layer, a top electrode, a bottom electrode and a passivation layer of the parallel resonator.

12. The semiconductor structure according to any one of claims 1 to 9, wherein one of the two adjacent stacked upper and lower units is a receiving filter unit, and another one of the two adjacent stacked upper and lower units is a transmitting filter unit.

13. The semiconductor structure according to any one of claims 1 to 9, further comprising:
at least one filter comprising series resonators and parallel resonators, the series resonators of a same filter of the at least one filter being arranged on one substrate of the substrates, and the parallel resonators of the same filter being arranged on another substrate of the substrates that is different from the one substrate; or
at least one filter comprising series resonators and parallel resonators, a thickness of at least one of a top electrode, a piezoelectric layer, a bottom electrode and a passivation layer of the series resonator of a same filter being different from a corresponding one of thicknesses of a top electrode, a piezoelectric layer, a bottom electrode and a passivation layer of the parallel resonator of the same filter.

14. The semiconductor structure according to claim 1, wherein the barrier layer is made of at least one of aluminum nitride, silicon nitride, silicon oxide, or silicon dioxide.

15. A method of manufacturing a semiconductor structure with stacked units, comprising:
providing a protective layer having an upper surface and a lower surface;
providing a plurality of units, each of the plurality of units comprising a substrate, the plurality of units comprising at least one intermediate unit located between the protective layer and a lowermost unit of the plurality of units; and
sequentially stacking the plurality of units on the lower surface of the protective layer in a thickness direction of the protective layer, a first accommodating space being provided between the protective layer and a substrate of a topmost unit of the plurality of units, a second accommodating space being provided between substrates of two adjacent stacked upper and lower units of the plurality of units, and a substrate of at least one of the plurality of unit being provided with a chip that is located in a corresponding one of the first accommodating space and the second accommodating space,
wherein the providing the at least one intermediate unit comprises:
providing a plurality of bonding structures on an upper surface of a substrate of the at least one intermediate unit, each of the plurality of bonding structures comprising a barrier layer and an upper metal bonding layer arranged sequentially from bottom to top, and the barrier layer being made of a material that is different from a material of the substrate where the barrier layer is located and is different from a material of the upper metal bonding layer;
providing a plurality of protrusion structures on a lower surface of the substrate of the at least one intermediate unit, each of the plurality of protrusion structures being formed by thinning the substrate of the at least one intermediate unit, and each of the plurality of protrusion structures corresponding to one bonding structure of the plurality of bonding structures and align with the one bonding structure in a thickness direction of the substrate of the at least one intermediate unit;
performing, by a first etching process, a first etching step on the lower surface of the substrate of the at least one intermediate unit to form intermediate substrate through holes, each of the intermediate substrate through holes passing through one of the plurality of protrusion structures and the substrate of the at least one intermediate unit and terminating at a barrier layer of the one bonding structure; and
performing, by a different etching process, a second etching step on the lower surface of the substrate of the at least one intermediate unit, in such a manner that the intermediate substrate through hole further extends through the barrier layer and terminates at the upper metal bonding layer; and
where the method further comprises filling the intermediate substrate through holes with a conductive metal to form intermediate substrate conductive through holes.

16. The method according to claim 15, wherein the protective layer and the plurality of unit each form a layer, and two adjacent layers are stacked in a metal bonding mode, and the method further comprises:
providing a metal protrusion structure bonding layer on the protrusion structure,
wherein the metal protrusion structure bonding layer is electrically connected to a corresponding one of the intermediate substrate conductive through holes.

17. The method according to claim 16, wherein the upper metal bonding layer arranged on an upper side of the substrate of the intermediate unit has a metal bonding through hole aligning with a corresponding one of the intermediate substrate through holes; and
the metal protrusion structure bonding layer arranged on a lower side of the substrate of the intermediate unit has a metal bonding through hole aligning with a corresponding one of the intermediate substrate through holes.

18. The method according to claim 17, wherein the intermediate substrate through hole is a part of an integrated through hole structure extending from the upper surface of the protective layer downwardly through the at least one intermediate unit.

19. The method according to claim 18, wherein the intermediate substrate through hole is a part of an integrated through hole structure that extends from the upper surface of the protective layer downwardly through the at least one intermediate unit to be electrically connected to the lowermost unit.

20. The method according to claim 18 or 19, wherein the filling the intermediate substrate through hole with the conductive metal comprises filling the integrated conductive through hole structure with the conductive metal at one time from the upper surface of the protective layer to form an integrated conductive through hole structure.

21. The method according to any one of claims 15 to 20, wherein in the providing the protective layer, the protective layer is provided with protective layer holes partially entering from the lower surface of the protective layer, and the protective layer hole aligns with the intermediate substrate through hole; and
the method further comprises thinning the protective layer from the upper surface of the protective layer to expose the protective layer holes, in such a manner that the protective layer holes each are a protective layer through hole.

22. The method according to claim 21, further comprising:
forming conductive pads on the upper surface of the protective layer, and each of the conductive pads being electrically connected to one of the protective layer through holes.

23. An electronic apparatus, comprising the semiconductor structure according to any one of claims 1 to 14 or a semiconductor structure manufactured by the method according to any one of claims 15 to 22.
